(19) **Europäisches Patentamt / European Patent Office / Office européen des brevets**

(11) **EP 2 978 026 A1**

(12) **EUROPEAN PATENT APPLICATION**
published in accordance with Art. 153(4) EPC

(43) Date of publication:
27.01.2016 Bulletin 2016/04

(21) Application number: 14768001.1

(22) Date of filing: 17.03.2014

(51) Int Cl.:
*H01L 31/0236* (2006.01)   *H01L 31/0747* (2012.01)
*H01L 31/18* (2006.01)

(86) International application number:
PCT/JP2014/057189

(87) International publication number:
WO 2014/148443 (25.09.2014 Gazette 2014/39)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 19.03.2013 JP 2013056747

(71) Applicant: Choshu Industry Co., Ltd.
Sanyo-onoda-shi, Yamaguchi 757-8511 (JP)

(72) Inventor: KOBAYASHI Eiji
Sanyo-onoda-shi
Yamaguchi 757-8511 (JP)

(74) Representative: von Kreisler Selting Werner -
Partnerschaft
von Patentanwälten und Rechtsanwälten mbB
Deichmannhaus am Dom
Bahnhofsvorplatz 1
50667 Köln (DE)

(54) **PHOTOVOLTAIC ELEMENT AND MANUFACTURING METHOD THEREFOR**

(57)   Provided are: a photovoltaic element that achieves an increased electrical efficiency due to having a pyramidal texture provided through etching a silicon substrate without the use of any organic solvent harmful to humans; and a manufacturing method therefor. A photovoltaic element 10 includes: a silicon substrate 11 having a pyramidal texture on the surface thereof, the pyramidal texture including a large number of pyramids and being provided through anisotropic etching; and amorphous silicon thin films 12 to 15 provided on the pyramidal texture through chemical vapor deposition, wherein the average length of diagonals of the square at base of the pyramids is adjusted to less than 5 $\mu$m through selection of etching conditions, the average length of diagonals being defined by the following formula of:

average length of diagonals = (2 * "area of visual field"/ "number of vertices of pyramids found in visual field")$^{0.5}$.

Fig.1

**Description**

[TECHNICAL FIELD]

The present invention relates to a photovoltaic element for use in silicon-based thin film heterojunction solar batteries, in particular, a photovoltaic element achieving a higher electrical efficiency and being applicable to thinner type batteries, and to a manufacturing method therefor.

[BACKGROUND ART]

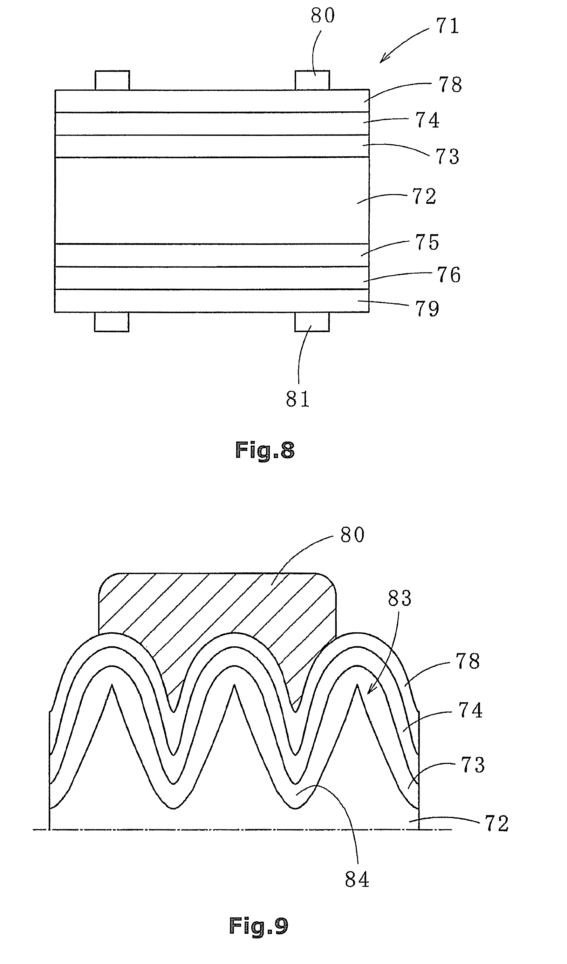

In these days, a large reduction of $CO_2$ emission has been advocated worldwide as a measure for global warming, and photo-electric power generating devices (solar panels) are in widespread use as a clean energy source that does not emits gases such as $CO_2$. Among these, a photo-electric power generating device that is provided with a heterojunction photo-electric power generating element achieving an increased electrical efficiency has attracted widespread attention. The photo-electric power generating device includes a plurality of photo-electric power generating elements (photovoltaic elements) 71 as shown in FIG. 8. The photo-electric power generating element 71 includes: a p-type amorphous silicon thin film layer 74 overlaid on one face (upper face) side of an n-type single crystal silicon substrate (c-Si) 72 with an intrinsic amorphous silicon layer (i-layer) 73 interposed between the n-type single crystal silicon substrate 72 and the p-type amorphous silicon thin film layer 74; an n-type amorphous silicon thin film layer 76 overlaid on the other face (inferior face) side of the n-type single crystal silicon substrate (c-Si) 72 with an intrinsic amorphous silicon layer (i-layer) 75 interposed between the n-type single crystal silicon substrate 72 and the n-type amorphous silicon thin film layer 76; transparent conductive oxide layers 78, 79 overlaid on the p-type amorphous silicon thin film layer 74 and underneath the n-type amorphous silicon thin film layer 76, respectively; and comb-shaped collector electrodes (finger electrodes) 80, 81 joined to the transparent conductive oxide layers 78, 79, respectively.

Moreover, in order to further increase a light receiving efficiency, a large number of pyramidal protrusions and depressions (may be generally referred to as "pyramidal texture" in the entirety) 83 arranged along the (111) plane are provided, as shown in FIG. 9, by subjecting the n-type single crystal silicon substrate 72 that has been sliced along the (100) plane to anisotropic etching. In particular, Patent Document 1 discloses that the efficiency (specifically, an FF value) of the photovoltaic element can be increased by roundly forming valley portions 84 of the pyramidal texture 83, and thereby reducing the non-uniformity of the thickness of the intrinsic amorphous silicon layer 73 that is deposited through plasma CVD to coat the n-type single crystal silicon substrate 72.

Patent Document 1 (page 9, lines 20 to 31) also discloses forming pyramids having a height of about 1 to about 10 $\mu$m by using in an anisotropic etching, 2% by weight sodium hydroxide, and isopropyl alcohol which inhibits bubble generation. However, it is also disclosed that isopropyl alcohol needs to be replenished because of volatility of isopropyl alcohol, and to be strictly managed because of adverse effects of isopropyl alcohol on a working environment. Moreover, since isopropyl alcohol increases costs due to its costliness. In such circumstances, Patent Document 1 is entirely silent as to actions and performances of a photovoltaic element that is provided with pyramidal protrusions having a height of about 1 to about 10 $\mu$m.

Patent Document 1 discloses manufacturing a silicon substrate being superior in a light trapping effect and provided with the pyramidal texture including pyramids each having a width of 5 $\mu$m and a height of 5 $\mu$m by replacing isopropyl alcohol by a surfactant (for example, Sintrex manufactured by Nippon Oil and Fat Co. Ltd.), and using an etchant prepared by the addition of 1% by weight of the aforementioned surfactant to a 1.5% by weight aqueous NaOH solution, for an etching time period of 30 min. It is disclosed that thereafter isotropic etching is executed by immersing the silicon substrate in an aqueous solution prepared by mixing hydrofluoric acid and nitric acid, thereby allowing the valley portions of the pyramidal texture to have a roundness corresponding to a curved surface the radius of which is no less than 0.1 $\mu$m, and then an intrinsic amorphous silicon layer having a thickness of 50 to 200 Å is deposited through plasma CVD using a silane gas ($SiH_4$).

[PRIOR ART DOCUMENTS]

Patent Document 1: PCT International Publication No. 98/43304

[Nonpatent Documents]

Nonpatent Document 1: Properties of interfaces in amorphous/crystalline silicon heterojunctions, Sara Olibet et al., Phys. Status Solidi A, 1-6 (2010)

[SUMMARY OF THE INVENTION]

[PROBLEMS TO BE SOLVED BY THE INVENTION]

The present inventor actually experimented the technique disclosed in Patent Document 1, and found that not only the FF value but also a value of an open circuit voltage Voc could be increased. Then, based on these findings, the present inventor formed the pyramidal texture without using a harmful organic solvent such as isopropyl alcohol, and defined a relationship between the length of the diagonals of the square at base of the pyramids in the pyramidal texture (hereinafter, may be also merely referred to as "diagonals" or "diagonals of pyramids") as a parameter, and an electrical efficiency through experimentation.

Furthermore, problems were also found that: when the size of the pyramidal structures was increased, a thicker silicon substrate was necessary, and the amount of a metal paste (typically, silver paste) used in the comb-shaped collector electrode provided on the transparent conductive oxide layer increased.

It is to be noted that details of Nonpatent Document 1 will be discussed later.

The present invention was made in view of the foregoing circumstances, and it is an object of the present invention to provide: a photovoltaic element that achieves an increased electrical efficiency due to having a pyramidal texture provided through etching a silicon substrate without the use of any organic solvents costly and harmful to humans; and a manufacturing method therefor.

[MEANS FOR SOLVING THE PROBLEMS]

A photovoltaic element according to a first aspect of the present invention that attains the aforementioned object includes: a silicon substrate having a pyramidal texture on the surface thereof, the pyramidal texture including a large number of pyramids and being provided through anisotropic etching; and an amorphous silicon thin film provided on the pyramidal texture through chemical vapor deposition, wherein the average length of diagonals of a square at base of the pyramids is less than 5 $\mu$m, the average length of diagonals being defined by the following formula of:

$$\text{average length of diagonals} = (2 * \text{"area of visual field"} / \text{"number of vertices of pyramids found in visual field"})^{0.5}.$$

In the photovoltaic element according to the first aspect of the present invention, an etching treatment for intentionally rounding valley portions of the pyramidal texture is not executed.

It is to be noted that in regard to the pyramidal structures having a width of the square at base of 5 $\mu$m and a depth of the square at base of 5 $\mu$m disclosed in Patent Document 1, the width is presumed to refer to the length of sides, and hence in this case, the average length of the diagonals would be about 7 $\mu$m.

In a second aspect of the present invention, the photovoltaic element according to the first aspect of the present invention is provided, in which at least the amorphous silicon thin film directly joined to the silicon substrate is overlaid through the chemical vapor deposition in a state in which the temperature of the silicon substrate is greater than 180 °C and no greater than 220 °C.

In a third aspect of the present invention, the photovoltaic element according to the first or second aspect of the present invention is provided, in which the thickness of the silicon substrate is 70 to 120 $\mu$m.

In a fourth aspect of the present invention, the photovoltaic element according to the first to third aspects of the present invention is provided, which includes a finger electrode on the front face, wherein the thickness of the finger electrode is 1 to 5 $\mu$m.

In a fifth aspect of the present invention, the photovoltaic element according to the first to fourth aspects of the present invention is provided, in which the average length of the diagonals is 2 to 4 $\mu$m.

In a sixth aspect of the present invention, the photovoltaic element according to the first to fifth aspects of the present invention is provided, which has an open circuit voltage of no less than 720 mV.

A solar battery module according to a seventh aspect of the present invention includes the photovoltaic element according to the first to sixth aspects of the present invention.

Moreover, a solar battery system according to an eighth aspect of the present invention includes the solar battery module according to the seventh aspect of the present invention.

A method for manufacturing a photovoltaic element according to a ninth aspect of the present invention is a method for manufacturing a photovoltaic element including: a silicon substrate having a pyramidal texture on the surface thereof, the pyramidal texture including a large number of pyramids and being provided through anisotropic etching; and an amorphous silicon thin film provided on the pyramidal texture through chemical vapor deposition, the method including:

etching to obtain the silicon substrate by the anisotropic etching of an unetched silicon substrate without using isopropyl alcohol and through using a mixed liquid containing an alkali, water, and an additive containing at least one of an alcohol derivative and a surfactant, wherein the average length of diagonals of a square at base of pyramids is less than 5 $\mu$m, the average length of diagonals being defined by the following formula of:

```
average length of diagonals = (2 * "area of visual
field"/ "number of vertices of pyramids found in visual
field")^0.5.
```

Further, in a tenth aspect of the present invention, the method for manufacturing a photovoltaic element according to the ninth aspect of the present invention is provided, in which the alkali concentration of the mixed liquid is, for example, 0.2 to 2% by mass (preferably less than 1% by mass) in terms of NaOH equivalent, and the etching further includes cleaning the silicon substrate by a cleaning treatment including immersing the unetched silicon substrate in the mixed liquid for 10 to 20 min.

Thus, since the surfactant is added to the alkaline solution (mixed liquid), reattaching of small fragments of silicon or reaction products generated during the etching to the silicon substrate, and the resultant occurrence of fine defects (minute roughness) on the surface of a silicon substrate can be prevented. In addition, when the alcohol derivative (i.e., a compound derived from the alcohol and exemplified by a carboxylic acid, an aldehyde, an ester and the like; use of an alcohol derivative that is harmless to humans being preferred) is added to the alkaline solution (mixed liquid), an etching reaction on the surface of the silicon substrate can be appropriately suppressed, and consequently the pyramidal texture can be formed effectively on the surface of the silicon substrate.

The concentration of sodium hydroxide, potassium hydroxide or the like in the alkaline solution is preferably 0.2 to 2% by mass (in terms of sodium hydroxide equivalent; preferably, less than 1% by mass), the concentration of the additive is preferably 0.05 to 0.5% by mass, and the treatment temperature is preferably 75 to 90 °C. Since a longer etching time period results in a decrease of a production efficiency, the concentration ratio of the alkali reagent (alkali) to the additive is preferably adjusted such that the etching treatment is completed within about 10 to about 20 min. For example, in a case where the pyramids are formed compactly and densely within a shorter period of time, the concentration of the additive may be increased while the concentration of the alkali reagent is decreased.

Moreover, it is typically preferred that after executing the etching treatment, a cleaning treatment is executed using pure water or a cleaning agent equivalent thereto. It is to be noted that another etching is preferably executed before the aforementioned etching step for providing the pyramidal texture, for the purpose of eliminating a damaged layer, i.e., the etching treatment is preferably executed in two steps. For example, the damaged layer generated in a step of slicing the silicon substrate and being present on the surface of the substrate is first eliminated by increasing an etching rate through use of the alkali concentration of no less than 5% by mass and thereby enhancing isotropy. After the elimination of the damaged layer, the aforementioned etching step for providing the pyramidal texture is preferably executed with enhanced anisotropy.

[EFFECTS OF THE INVENTION]

According to the photovoltaic element and the manufacturing method therefor of the aspects of the present invention, a photovoltaic element can be provided which achieves a higher electrical efficiency (Pmax) than conventional photovoltaic elements. Moreover, since the length of the diagonals of the pyramidal structures is smaller than that of the conventional photovoltaic elements, a time period required for manufacture of the silicon substrate can be shortened, thereby enabling a production efficiency to be increased.

Further, since a smaller etching amount is required, a thinner silicon substrate can be used, thereby enabling a requirement of a material of the silicon substrate to be reduced.

Furthermore, since the depth (height) of the pyramids is decreased, the thickness of a collector electrode provided on the surface of the photovoltaic element can be decreased, and therefore an amount of a material (for example, silver) of the collector electrode can also be reduced.

[BRIEF DESCRIPTION OF THE DRAWINGS]

FIG. 1 shows a cross sectional view of an photovoltaic element according to an embodiment of the present invention;
FIG. 2 shows an explanatory view illustrating the length of diagonals of the square at base of a pyramid;
FIG. 3 shows a micrograph of an etched silicon substrate in which an average length of the diagonals is 7 $\mu$m;

FIG. 4 shows a micrograph of an etched silicon substrate in which an average length of the diagonals is 5 $\mu$m;

FIG. 5 shows a micrograph of an etched silicon substrate in which an average length of the diagonals is 4 $\mu$m;

FIG. 6 shows a micrograph of an etched silicon substrate in which an average length of the diagonals is 3 $\mu$m;

FIG. 7 shows a micrograph of an etched silicon substrate in which an average length of the diagonals is 2 $\mu$m;

FIG. 8 shows a cross sectional view of a conventional photovoltaic element; and

FIG. 9 shows a partial enlarged cross sectional view of the conventional photovoltaic element.

[DESCRIPTION OF EMBODIMENTS]

Subsequently, embodiments for carrying out the present invention will be explained with reference to the attached drawings.

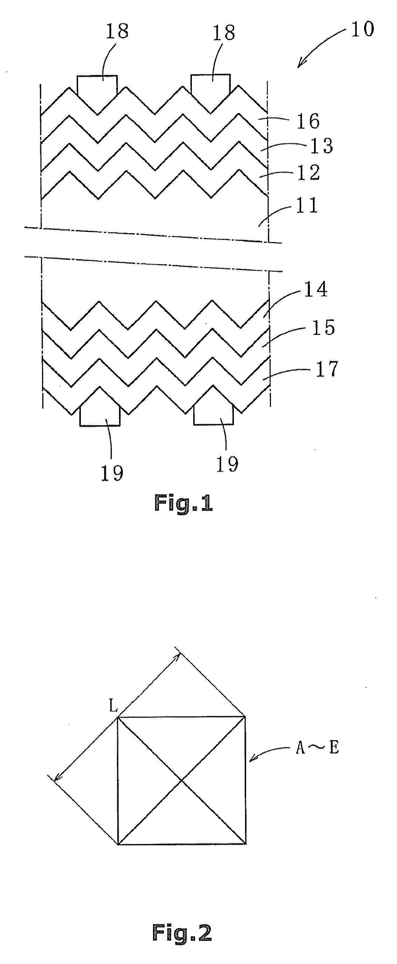

With reference to FIG. 1, an photovoltaic element 10 according to an embodiment of the present invention constitutes an amorphous silicon thin film heterojunction solar battery, and includes: an n-type single crystal silicon substrate (c-Si; hereinafter, may be also merely referred to as "silicon substrate") 11 in a central portion thereof; a p-type amorphous silicon thin film layer 13 overlaid on the upper face side of the silicon substrate 11 with an intrinsic amorphous silicon thin film layer (i-layer) 12 interposed between the silicon substrate 11 and the p-type amorphous silicon thin film layer 13; an n-type amorphous silicon thin film layer 15 overlaid on the inferior face side of the silicon substrate 11 with an intrinsic amorphous silicon thin film layer (i-layer) 14 interposed between the silicon substrate 11 and the n-type amorphous silicon thin film layer 15; transparent conductive oxide layers 16, 17 overlaid on the p-type amorphous silicon thin film layer 13 and underneath the n-type amorphous silicon thin film layer 15, respectively; and comb-shaped collector electrodes (finger electrodes) 18, 19 overlaid on the surfaces of the transparent conductive oxide layers 16, 17, respectively.

The upper and inferior faces of the silicon substrate 11 are subjected to a treatment for providing a pyramidal texture through anisotropic etching with a chemical method in order to achieve more effective light trapping by way of diffuse reflection of rays of light. More specifically, a large number of pyramidal structures can be formed by immersing an unetched silicon substrate having been sliced along the (100) plane (with a damaged layer having been eliminated) in an alkaline aqueous solution (mixed liquid) containing, for example, 0.2 to 2% by mass (more preferably 0.5 to 1.5% by mass, and still more preferably less than 1% by mass) of sodium hydroxide, or equivalent potassium hydroxide. The pyramidal structures are formed due to a significantly smaller etching rate along the (111) plane compared with that along other crystal orientation. When the alkali concentration of the mixed liquid is, for example, greater than 2% by mass and as great as about 5% by mass, isotropic etching is allowed, and hence the large number of pyramidal structures are unlikely to be formed.

In this treatment, when an aqueous isopropyl alcohol solution is used as the etchant (mixed liquid), isopropyl alcohol is volatilized and deteriorates a working environment, as described in the foregoing. Therefore, isopropyl alcohol is not used, whereas an additive containing at least one of an alcohol derivative and a surfactant is used. The boiling point of the alcohol derivative and the surfactant is preferably no less than 100 °C. As the additive, commercially available "ALKA-TEX" manufactured by GP Solar GmbH, etc., for example, may be used. In this embodiment, "ALKA-TEX ZERO" among "ALKA-TEX" series products available from GP Solar GmbH is used. In other words, a mixed liquid constituted with an alkali such as sodium hydroxide or potassium hydroxide, "ALKA-TEX ZERO" (an example of the additive containing at least one of an alcohol derivative and a surfactant) and water may be used as an etchant. In addition, it is preferred that the unetched silicon substrate is immersed in the mixed liquid for 10 to 20 min, and thereafter the silicon substrate 11 having the pyramidal structures provided thereon is subjected to a cleaning treatment.

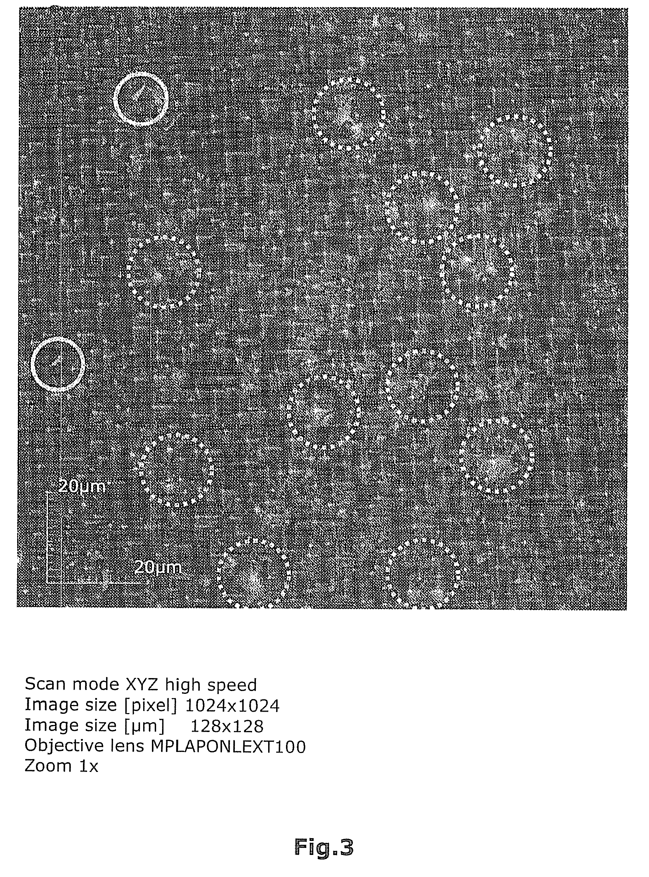

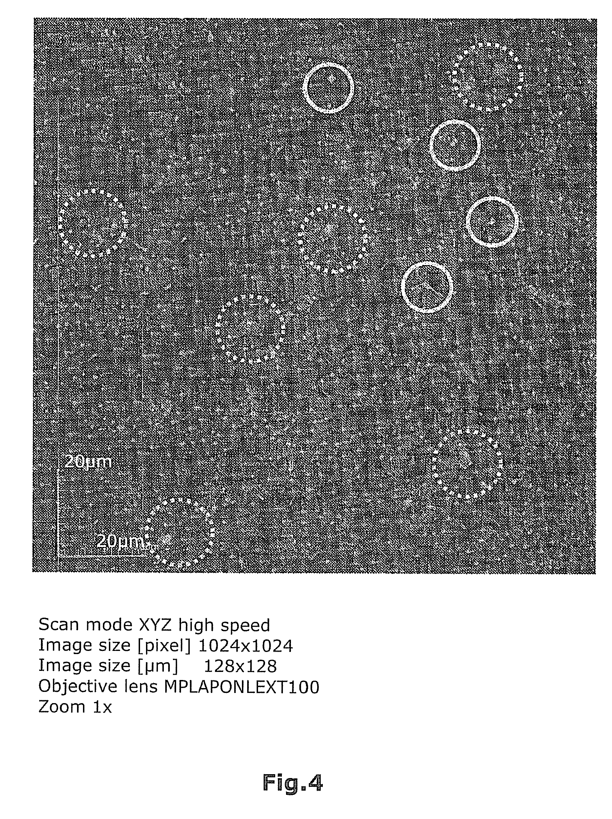

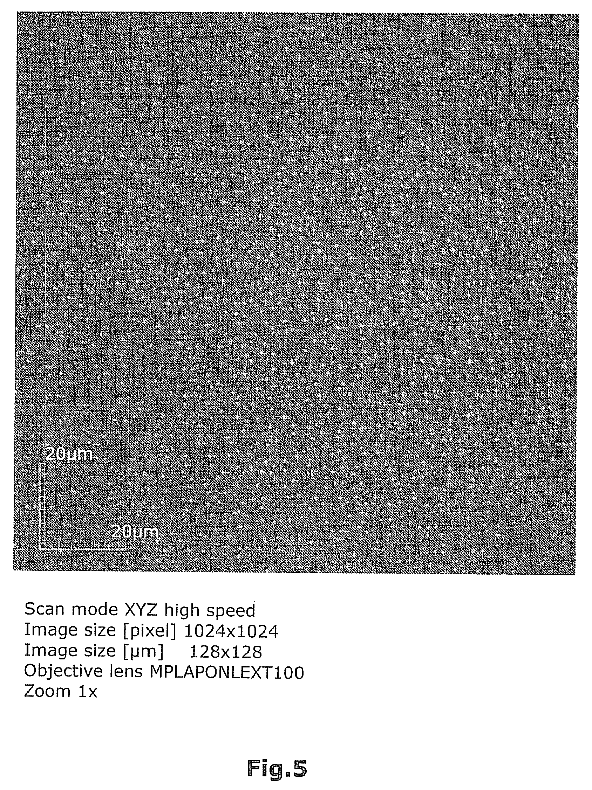

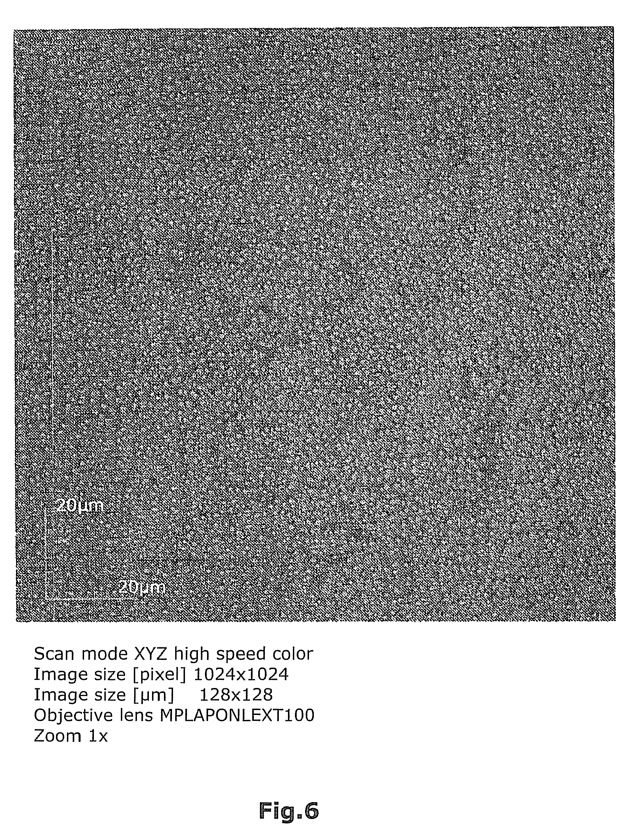

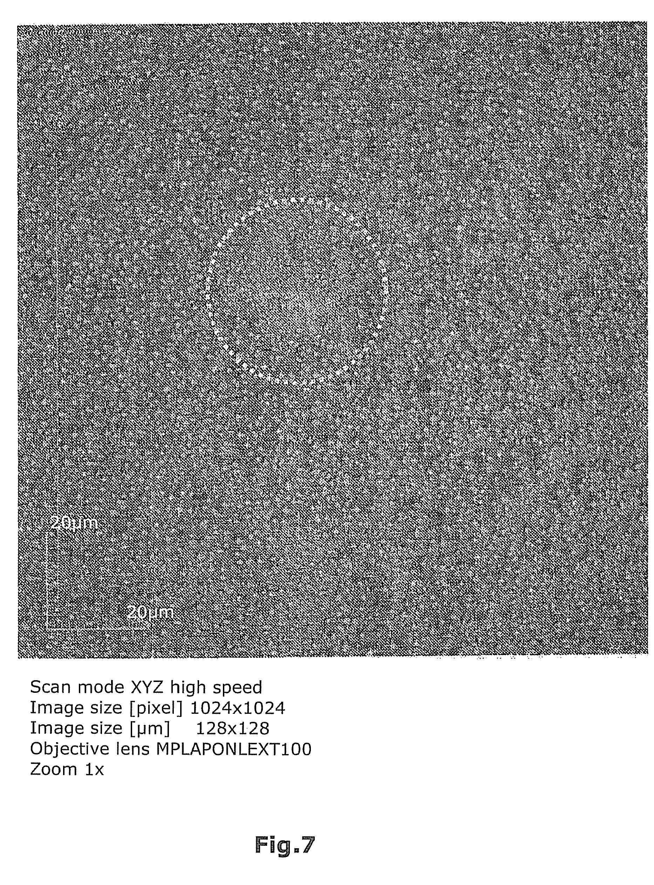

By controlling the concentration of the etchant and the etching time period, pyramidal textures A to E which differ in size of the pyramidal structures can be formed, as shown in FIGs. 3 to 7, respectively. A specific procedure involves: (1) $H_2O$ rinsing (room temperature); (2) NaOH (5% by mass, 85 °C); (3) $H_2O$ rinsing (room temperature); (4) NaOH/ ALKA-TEX ZERO (Table 1); (5) $H_2O$ rinsing (room temperature); (6) HCl/ $H_2O_2$/ $H_2O$ (volume ratio of 1:1:5, 80 °C); (7) $H_2O$ rinsing (room temperature); (8) HF/ $H_2O$ (5% by mass, room temperature); and (9) $H_2O$ rinsing (room temperature). The thickness of the sliced silicon substrate (the thickness of the unetched silicon substrate) is 180 $\mu$m, and the finished thickness of the etched silicon substrate is 165 $\mu$m. It is to be noted that the thickness of the unetched silicon substrate may be decreased, and the thickness (average thickness) of the finished silicon substrate may be 70 to 120 $\mu$m. Thus, a further thinner photovoltaic element that achieves a high economical efficiency can be provided.

The average length L of diagonals of the pyramids constituting the pyramidal textures A to E is defined as: (2 * "area of visual field"/ "number of vertices of pyramids found in visual field")$^{0.5}$, as shown in FIG. 2. In this embodiment, pyramidal structures having the average length L of 7 $\mu$m (A), 5 $\mu$m (B), 4 $\mu$m (C), 3 $\mu$m (D), and 2 $\mu$m (E) are formed. The identifiers (A) to (E) as used herein designate the silicon substrates shown in FIGs. 3 to 7, respectively.

It is to be noted that FIGs. 3 to 7 show laser microscopic images captured using a laser microscope OLS4000 manufactured by Olympus Corporation. In the definition of the average length L of the diagonals, a visual field of a laser microscopic image per capturing is 128 $\mu$m * 128 $\mu$m. The number of vertices of pyramids found within the visual field is counted, and the average length L of the diagonals of the pyramids constituting the pyramidal texture was calculated. Actually, the number of vertices of the pyramids found in the laser microscopic image was counted at: one point near the center of the silicon substrate; and four points situated between the center and four respective corners of the silicon substrate, i.e. five points in total. Thus, the average length L of the diagonals was calculated.

Moreover, the concentration of the etchant, the etching time period, and the etching temperature are as shown in Table 1.

Table 1

| Sample | Alkali reagent | Additive | Alkali reagent concentration (% by mass) | Additive concentration (% by mass) | Etching time period (min.) | Etching temperature (°C) |
|---|---|---|---|---|---|---|
| A | sodium hydroxide | ALKA-TEX ZERO | 1.2 | 0.05 | 26 | 80 |
| B | sodium hydroxide | ALKA-TEX ZERO | 0.8 | 0.06 | 23 | 80 |
| C | sodium hydroxide | ALKA-TEX ZERO | 0.7 | 0.07 | 20 | 80 |
| D | sodium hydroxide | ALKA-TEX ZERO | 0.5 | 0.07 | 15 | 80 |
| E | sodium hydroxide | ALKA-TEX ZERO | 0.3 | 0.1 | 15 | 80 |

Next, the amorphous silicon thin films (i.e., the intrinsic amorphous silicon thin film layer (i-layer) 12, the p-type amorphous silicon thin film layer 13, the intrinsic amorphous silicon thin film layer (i-layer) 14, and the n-type amorphous silicon thin film layer 15) are formed on the surface of each silicon substrate 11 having each of the pyramidal textures A to E provided thereon through plasma CVD (one exemplary chemical vapor deposition). For example, in the case of the formation of the p-type amorphous silicon thin film layer 13, a gas mixture of $SiH_4$, $H_2$, $PH_3$ and $B_2H_6$ may be used as a source gas in the plasma CVD.

In the case of the formation through the plasma CVD, the frequency is, for example, about 13.56 MHz or about 40.68 MHz, and more preferably about 40.68 MHz; the reaction pressure is no less than 5 Pa and less than 300 Pa, and more preferably no less than 50 Pa and less than 200 Pa; and the RF or VHF power is, for example, no less than about 1 $mW/cm^2$ and less than 500 $mW/cm^2$, and more preferably about no less than 5 $mW/cm^2$ and less than 100 $mW/cm^2$. The temperature (formation temperature) of the silicon substrate 11 in overlaying each amorphous silicon thin film may be greater than 180 °C and no greater than 220 °C. When the formation temperature falls within the comparatively high temperature range described above, crystallization can be inhibited, whereby an amorphous thin film with reduced generation of defects can be obtained. The effects exerted by controlling the formation temperature are particularly remarkable in the formation of the thin films (the intrinsic amorphous silicon thin film layer (i-layer) 12, and the amorphous silicon thin film layer (i-layer) 14) directly joined to the silicon substrate 11 having fine roughness on the surface thereof. Specifically, local generation of an epitaxial film in groove portions of the pyramidal texture can be inhibited.

Thereafter, the transparent conductive oxide layers 16, 17 are formed on the upper and inferior faces through an ion plating technique, and then the comb-shaped collector electrodes 18, 19 are formed through a screen printing technique.

The relationships of the average length L of the diagonals of the pyramids in the pyramidal textures A to E with the short circuit current density, the open circuit voltage, the fill factor and the conversion efficiency are shown in Table 2.

Table 2

| Sample | Average length L of diagonals ($\mu$m) | Short circuit current density (mA/cm2) | Open circuit voltage (V) | Fill factor | Conversion efficiency (%) |
|---|---|---|---|---|---|
| A | 7 | 38.7 | 0.719 | 0.794 | 22.1 |
| B | 5 | 38.8 | 0.720 | 0.800 | 22.3 |
| C | 4 | 38.9 | 0.723 | 0.812 | 22.8 |
| D | 3 | 38.9 | 0.723 | 0.810 | 22.8 |

(continued)

| Sample | Average length L of diagonals ($\mu$m) | Short circuit current density (mA/cm2) | Open circuit voltage (V) | Fill factor | Conversion efficiency (%) |
|---|---|---|---|---|---|
| E | 2 | 38.8 | 0.721 | 0.799 | 22.4 |

The pyramidal textures (C) and (D) corresponding to the average length L of the diagonals of 4 $\mu$m and 3 $\mu$m, respectively, resulted in a high short circuit current density. A difference in the short circuit current density results from a small reflectance on the surface of a silicon substrate. The pyramidal textures (A) and (B) corresponding to the average length L of the diagonals of 7 $\mu$m and 5 $\mu$m, respectively, included: regions in which the (100) plane remained on the surface of the silicon substrate without the formation of the pyramidal structures (regions surrounded by a solid line circle in the Figures); and regions in which the pyramidal structures were overetched (regions surrounded by a dotted line circle in the Figures). These are presumed to be causes for an increase of the reflectance. The regions in which the pyramidal structures were overetched (regions surrounded by a dotted line circle in the Figures) were also found in the pyramidal texture (E) corresponding to the average length L of the diagonals of 2 $\mu$m.

The pyramidal textures (C) and (D) corresponding to the average length L of the diagonals of 4 $\mu$m and 3 $\mu$m, respectively, resulted in a high open circuit voltage. A high open circuit voltage results from a great minority carrier lifetime.

The regions in which the (100) plane remained on the surface of the silicon substrate without the formation of the pyramidal structures (regions surrounded by a solid line circle in the Figures) were found in the pyramidal textures (A) and (B) corresponding to the average length of the diagonals of 7 $\mu$m and 5 $\mu$m, respectively, and these are presumed to be causes for a decrease of the minority carrier lifetime.

The pyramidal textures (C) and (D) corresponding to the average length of the diagonals of 4 $\mu$m and 3 $\mu$m, respectively, resulted in a great fill factor. Although a cause for the great fill factor has not been clarified in detail, the great fill factor is presumed to result from the roughness of the surface of the silicon substrate. Since the regions in which the pyramidal structures were overetched (regions surrounded by a dotted line circle in the Figures) were found in (A), (B) and (E) having the average length of the diagonals of 7 $\mu$m, 5 $\mu$m and 2 $\mu$m, respectively, it is presumed that junction characteristics between the regions and an amorphous silicon thin film overlaid on these regions are deteriorated, and the deterioration would cause an increase of a series resistance component.

Taking into consideration the foregoing comprehensively, it is believed that an improvement of the performances is achievable through minimizing to the possibly least extent: the regions in which the (100) plane remained on the surface of a silicon substrate without the formation of the pyramidal structures; and the regions in which the pyramidal structures were overetched. When the average length L of the diagonals of the pyramids in the pyramidal texture is defined as $(2 * \text{"area of visual field"}/ \text{"number of vertices of pyramids found in visual field"})^{0.5}$, the average length L of the diagonals needs to be less than 5 $\mu$m, and is preferably no less than 2 $\mu$m (more preferably no less than 3 $\mu$m) and no greater than 4 $\mu$m. When the length L of the diagonals of the pyramidal structures is no less than 5 $\mu$m, the regions in which the pyramidal structures are not formed and/or the regions in which the pyramidal structures are overetched may be increased, and hence the photovoltaic element may fail to achieve the maximum output thereof.

In addition, in light of an increases of the productivity owing to a shorter etching time period, it is preferred that the average length L of the diagonals is no less than 2 $\mu$m and less than 5 $\mu$m since the average length L falling within this range permits compact formation of the pyramidal structures even if a shorter etching time period is employed. When the average length L of the diagonals is less than 5 $\mu$m, in particular, is 2 to 4 $\mu$m, an etching amount along a depth direction can be reduced to be less than 3.5 $\mu$m (per one face); therefore, the aforementioned range of the average length L of the diagonals is also suitable for decreasing the thickness of the silicon substrate (for example, to 60 to 200 $\mu$m, more preferably 70 to 120 $\mu$m), leading to a reduction of the amount of the silicon used. In addition, the average length L of the diagonals of the pyramid is also closely related to the depth of the surface roughness. Thus, a collector electrode patterning in which the collector electrodes 18, 19 (finger electrodes) having a decreased thickness (for example, a thickness of 1 to 5 $\mu$m) are used is also enabled. When the finger electrodes are thus reduced in thickness, the amount of a silver paste and the like used may also be decreased, enabling a solar battery to be provided in lower costs. A method for forming a finger electrode having a reduced thickness preferably involves use of gravure offset printing, for example. The thickness of the finger electrode is preferably no less than 1 $\mu$m. When the finger thickness is less than 1 $\mu$m, it may be difficult to attain such a thickness, and furthermore the electric resistance may be increased.

Actual experimentation by the present inventor on the technique disclosed in Patent Document 1 reveled that not only the fill factor but also a value of the open circuit voltage could be increased. Nonpatent Document 1 discloses that when an epitaxial film is locally generated in the groove (valley) portions of the pyramidal texture, a surface recombination velocity increases four-fold, which causes the open circuit voltage to be significantly decreased. Although not clarified in detail, it is presumed that surface diffusion of radical species is less likely to occur in the groove portions of the pyramidal texture, and that as a result of the cooperation with a local stress applied as described in Nonpatent Document 1, an epitaxial film is locally formed in the groove portions of the pyramidal texture. It is presumed that in the technique disclosed in Patent Document 1, since local formation of the epitaxial film in the groove portions of the pyramidal texture is inhibited by roundly forming the pyramidal structure, not only the fill factor but also the open circuit voltage can be increased.

The inventor considered that in order to reduce the local epitaxial film without using the technique disclosed in Patent Document 1, it would be effective to increase the size of the pyramidal structures, and to reduce the groove portions. However, when the size of the pyramidal structures is increased, the regions in which the (100) plane remains on the surface of the silicon substrate without the formation of the pyramidal structures are likely to be generated, leading to a decrease of the open circuit voltage. Accordingly, when the etching time period was extended in order to reduce the (100) plane region, it was found that the regions in which the pyramidal structures were overetched were likely to be generated, leading to a decrease of the fill factor.

Nonpatent Document 1 discloses that the surface recombination velocity on the (100) plane is 40 times greater than that on the (111) plane; therefore, it is considered that an exposure of the (100) plane causes a significant decrease of the open circuit voltage, even if the exposure area is small. On the other hand, in this embodiment of the present invention, when the average length L of the diagonals of the square at base of the pyramids in the pyramidal texture is defined as (2 * "area of visual field"/ "number of vertices of pyramids found in visual field")$^{0.5}$, an open circuit voltage as high as no less than 720 mV has been achieved even though the average length L of the diagonals is no less than 2 $\mu$m and less than 5 $\mu$m, with the number of the groove portions of the pyramidal texture increased. This result is also related to the formation of the amorphous silicon thin film on the silicon substrate through chemical vapor deposition under comparatively high temperature conditions in which the temperature of the silicon substrate is greater than 180 °C and no greater than 220 °C. When the amorphous silicon thin film is formed at comparatively high temperatures, the surface diffusion of the radical species is activated, and hence the epitaxial film is less likely to be formed locally in the groove portions of the pyramidal texture. Thus, it is presumed that the aforementioned advantages exerted due to the (100) plane being hardly exposed are exhibited, and consequently a higher open circuit voltage is achieved. It is to be noted that although the aforementioned effects were achieved using "ALKA-TEX ZERO", the similar effects have been achieved using "TAD70" manufactured by Hayashi Pure Chemical Ind., Ltd. as an additive in place of "ALKA-TEX ZERO", suggesting that the effects are universal with respect to the average length of the diagonals.

The feature of the present invention is that the average length of the diagonals of the square at base of pyramids in the pyramidal texture of the silicon substrate is controlled so as to fall within the specific range, and the method of the anisotropic etching and chemicals used therein are not crucial. Therefore, techniques such as, for example, "a method of etching a silicon substrate" disclosed in Japanese Unexamined Patent Application, Publication No. 2010-74102, "an anisotropic silicon etchant composition" disclosed in Japanese Unexamined Patent Application, Publication No. 2009-206335, and "an etchant composition and an etching method" disclosed in Japanese Unexamined Patent Application, Publication No. 2012-227304 can be obviously applied to the embodiments of the present invention.

It is to be noted that a solar battery module according to another embodiment of the present invention includes the photovoltaic element described in the foregoing. Specifically, the solar battery module (solar battery panel) includes a basic structure in which a plurality of photovoltaic elements connected in series are sandwiched via an encapsulant between a front face panel such as glass and a back sheet. For example, techniques of "an electrode for photovoltaic cells, a photovoltaic cell and a photovoltaic module" disclosed in Japanese Unexamined Patent Application (Translation of PCT Application), Publication No. 2005-536894 can be applied to the embodiment of the present invention. By incorporating a collector electrode pattern in which finger electrodes having a reduced thickness (for example, a thickness of 1 to 5 $\mu$m) are used, a reduction of resistance can be achieved, whereby a more efficient solar battery module can be provided. Moreover, a solar battery system is configured by providing a required number of the solar battery modules. The solar battery module and the solar battery system are appropriately provided with a terminal for connection, a control means such as a control circuit, and the like.

The present invention is by no means limited to the aforementioned embodiments, and any modification can be made to the embodiments described above without departing from the spirit of the present invention. For example, the term "amorphous" as referred to herein means not only "amorphous" but also "microcrystalline", and these terms can be interchangeably used as appropriate.

For example, in the embodiments described above, light-reception can be performed on the front and back faces of the silicon substrate to permit electric power generation. On the other hand, if the light-reception is performed on only the front face, a more simplified configuration of the back face can be employed.

[EXPLANATION OF THE REFERENCE SYMBOLS]

10: photovoltaic element, 11: silicon substrate, 12: intrinsic amorphous silicon thin film layer, 13: p-type amorphous silicon thin film layer, 14: intrinsic amorphous silicon thin film layer, 15: n-type amorphous silicon thin film layer, 16, 17: transparent conductive oxide layer, 18, 19: comb-shaped collector electrode (finger electrode)

**Claims**

1. A photovoltaic element comprising:

a silicon substrate having a pyramidal texture on a surface thereof, the pyramidal texture comprising a large number of pyramids and being provided through anisotropic etching; and
an amorphous silicon thin film provided on the pyramidal texture through chemical vapor deposition,
wherein an average length of diagonals of a square at base of the pyramids is less than 5 $\mu$m, the average length of diagonals being defined by a formula of:

```
average length of diagonals = (2 * "area of visual
field"/ "number of vertices of pyramids found in visual
field")^{0.5}.
```

2. The photovoltaic element according to claim 1, wherein at least the amorphous silicon thin film directly joined to the silicon substrate has been overlaid through the chemical vapor deposition in a state in which a temperature of the silicon substrate is greater than 180 °C and no greater than 220 °C.

3. The photovoltaic element according to claim 1 or 2, wherein a thickness of the silicon substrate is 70 to 120 $\mu$m.

4. The photovoltaic element according to any one of claims 1 to 3, comprising a finger electrode on a front face thereof, wherein a thickness of the finger electrode is 1 to 5 $\mu$m.

5. The photovoltaic element according to any one of claims 1 to 4, wherein the average length of the diagonals is 2 to 4 $\mu$m.

6. The photovoltaic element according to any one of claims 1 to 5, having an open circuit voltage of no less than 720 mV.

7. A solar battery module comprising the photovoltaic element according to any one of claims 1 to 6.

8. A solar battery system comprising the solar battery module according to claim 7.

9. A method for manufacturing a photovoltaic element comprising: a silicon substrate having a pyramidal texture on a surface thereof, the pyramidal texture comprising a large number of pyramids and being provided through anisotropic etching; and an amorphous silicon thin film provided on the pyramidal texture through chemical vapor deposition, the method comprising:

etching to obtain the silicon substrate by the anisotropic etching of an unetched silicon substrate without using isopropyl alcohol and through using a mixed liquid comprising an alkali, water, and an additive comprising at least one of an alcohol derivative and a surfactant,
wherein an average length of diagonals of a square at base of the pyramids is less than 5 $\mu$m, the average length of diagonals being defined by a formula of:

```
average length of diagonals = (2 * "area of visual
field"/ "number of vertices of pyramids found in visual
field")^0.5.
```

**10.** The method for manufacturing a photovoltaic element according to claim 9, wherein
an alkali concentration of the mixed liquid is 0.2 to 2% by mass in terms of NaOH equivalent, and
the etching further comprises cleaning the silicon substrate by a cleaning treatment comprising immersing the unetched silicon substrate in the mixed liquid for 10 to 20 min.

**Fig.1**

**Fig.2**

Scan mode XYZ high speed
Image size [pixel] 1024x1024
Image size [µm]   128x128
Objective lens MPLAPONLEXT100
Zoom 1x

Fig.3

Scan mode XYZ high speed
Image size [pixel] 1024x1024
Image size [μm]    128x128
Objective lens MPLAPONLEXT100
Zoom 1x

Fig.4

Scan mode XYZ high speed
Image size [pixel] 1024x1024
Image size [μm]    128x128
Objective lens MPLAPONLEXT100
Zoom 1x

Fig.5

Scan mode XYZ high speed color
Image size [pixel] 1024x1024
Image size [µm]    128x128
Objective lens MPLAPONLEXT100
Zoom 1x

# Fig.6

Scan mode XYZ high speed
Image size [pixel] 1024x1024
Image size [μm]    128x128
Objective lens MPLAPONLEXT100
Zoom 1x

Fig.7

**Fig.8**

**Fig.9**

## INTERNATIONAL SEARCH REPORT

| International application No. |
|---|
| PCT/JP2014/057189 |

**A.   CLASSIFICATION OF SUBJECT MATTER**
*H01L31/0236*(2006.01)i, *H01L31/0747*(2012.01)i, *H01L31/18*(2006.01)i

According to International Patent Classification (IPC) or to both national classification and IPC

**B.   FIELDS SEARCHED**

Minimum documentation searched (classification system followed by classification symbols)
H01L31/0236, H01L31/0747, H01L31/18, H01L21/306, H01L21/308

Documentation searched other than minimum documentation to the extent that such documents are included in the fields searched
Jitsuyo Shinan Koho         1922–1996   Jitsuyo Shinan Toroku Koho   1996–2014
Kokai Jitsuyo Shinan Koho    1971–2014   Toroku Jitsuyo Shinan Koho   1994–2014

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| X<br>Y | US 2011/0174371 A1  (UNIVERSITÉ DE NEUCHÂTEL),<br>21 July 2011 (21.07.2011),<br>paragraphs [0023] to [0025]; fig. 3<br>& EP 2159851 A1        & EP 2332182 A1<br>& WO 2010/023318 A1    & CN 102165606 A | 1–8<br>9–10 |
| X | WO 1998/043304 A1  (Sanyo Electric Co., Ltd.),<br>01 October 1998 (01.10.1998),<br>entire text; all drawings<br>& JP 3271990 B         & US 6207890 B1<br>& US 2001/0029978 A1   & EP 1005095 A1<br>& AU 6420398 A         & CN 1251210 A | 1–10 |

☒   Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 March, 2014 (26.03.14) | 08 April, 2014 (08.04.14) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2014/057189

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2007-294830 A  (Sanyo Electric Co., Ltd.),<br>08 November 2007 (08.11.2007),<br>paragraph [0056]<br>& JP 2011-171773 A       & US 2006/0283496 A1<br>& EP 1734589 A2          & CN 1917236 A | 2 |
| A | JP 2012-064839 A  (Kaneka Corp.),<br>29 March 2012 (29.03.2012),<br>paragraph [0028]<br>(Family: none) | 3 |
| A | JP 07-142753 A  (Sanyo Electric Co., Ltd.),<br>02 June 1995 (02.06.1995),<br>paragraph [0011]<br>(Family: none) | 4 |
| A | JP 2009-164625 A  (Sanyo Electric Co., Ltd.),<br>23 July 2009 (23.07.2009),<br>table 2<br>& JP 2008-263171 A       & US 2008/0230122 A1<br>& EP 1973167 A2          & KR 10-2008-0085724 A<br>& CN 101271930 A | 6 |
| Y | JP 2011-515872 A  (Applied Materials Inc.),<br>19 May 2011 (19.05.2011),<br>paragraphs [0018] to [0027], [0031]<br>& JP 2012-501550 A       & US 2009/0280597 A1<br>& US 2011/0272625 A1      & US 2010/0055822 A1<br>& US 2010/0304527 A1      & US 2011/0183458 A1<br>& EP 2324509 A           & WO 2009/120631 A2<br>& WO 2010/025262 A2       & KR 10-2010-0125448 A<br>& CN 102017176 A          & TW 201001508 A<br>& CN 102132422 A | 9-10 |
| Y | JP 2010-074102 A  (Mitsubishi Electric Corp.),<br>02 April 2010 (02.04.2010),<br>entire text; all drawings<br>(Family: none) | 9-10 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9843304 A
- JP 2010074102 A
- JP 2009206335 A
- JP 2012227304 A
- JP 2005536894 W

**Non-patent literature cited in the description**

- **SARA OLIBET et al.** *Phys. Status Solidi A,* 2010, 1-6